Europäisches Patentamt

European Patent Office

Office européen des brevets

(19)

(11) Publication number : **0 508 760 A1**

## (12) EUROPEAN PATENT APPLICATION

(21) Application number : 92303134.8

(22) Date of filing : 08.04.92

(51) Int. Cl.⁵ : **H01L 27/108**

(30) Priority : **08.04.91 US 682149**

(43) Date of publication of application :
**14.10.92 Bulletin 92/42**

(84) Designated Contracting States :
**DE FR GB IT**

(71) Applicant : **SGS-THOMSON
MICROELECTRONICS, INC.
1310 Electronics Drive
Carrollton Texas 75006 (US)**

(72) Inventor : **Deptuch, Roland G.
18175 Midway, Apt. 134
Dallas, Texas 75287 (US)**
Inventor : **Chen, Fusen
18175 Midway, Apt. 227
Dallas, Texas 75287 (US)**

(74) Representative : **Palmer, Roger et al
PAGE, WHITE & FARRER 54 Doughty Street
London WC1N 2LS (GB)**

(54) **Dynamic random access memory cell.**

(57)   A dynamic random access memory cell includes a metal capacitor above an access transistor. Tungsten plugs are used to contact an active area of a device substrate. Tantalum is used for the charge storage plate of the capacitor, and oxidized to provide the capacitor dielectric. A tungsten reference plate can be deposited over the charge storage plate and dielectric to provide a common reference plate for all memory cells on the device. The tantalum oxide dielectric is formed on sidewalls of the charge storage plate, so that the capacitance of the capacitor can be increased by making the charge storage plate taller. This design allows overall cell size to shrink while maintaining adequate charge storage capacitance.

FIG. 5

EP 0 508 760 A1

The present invention relates generally to semiconductor integrated circuits, and more specifically to a design for a dynamic random access memory cell.

Dynamic random access memory (DRAMS) have one access transistor and one capacitor for each bit of memory. The capacitor stores charge indicating whether a logical 1 or 0 is stored in that bit. This design allows for a high density memory to be fabricated. The high densities realizable for DRAM devices causes the price to be relatively low.

To increase the density of DRAMS, the capacitor used for charge storage can be made smaller. However, shrinking the capacitor too far adversely affects device performance. To keep the capacitor large enough for proper device operation, designs which place the capacitor above the access transistor have been made.

Some of these designs are difficult to fabricate, increasing the cost of the memory device. In many cases, although some increase of capacitance has been made, it is difficult to increase the available capacitance by a large amount. As device features are scaled to smaller levels, the charge storage capacitor also becomes smaller. Thus, for extremely high density memory devices, the problems encountered with inadequate capacitance for the charge storage nodes becomes greater.

It would be desirable to provide a dynamic random access memory cell design which provides an adequately large capacitor for charge storage. It would be desirable for such a design to be one in which the capacitor can be kept relatively large as device feature sizes are made smaller.

It is therefore an object of the present invention to provide a dynamic random access memory cell having one transistor and one capacitor for charge storage.

It is another object of the present invention to provide such a cell which has improved capacitance for the charge storage capacitor.

It is a further object of the present invention to provide such a cell in which the capacitor can be maintained at an adequately large value as device feature sizes shrink.

Therefore, according to the present invention, a dynamic random access memory cell includes a metal capacitor above an access transistor. Tungsten plugs are used to contact an active area of a device substrate. Tantalum is used for the charge storage plate of the capacitor, and oxidized to provide the capacitor dielectric. A tungsten reference plate can be deposited over the charge storage plate and dielectric to provide a common reference plate for all memory cells on the device. The tantalum oxide dielectric is formed on sidewalls of the charge storage plate, so that the capacitance of the capacitor can be increased by making the charge storage plate taller. This design allows overall cell size to shrink while maintaining adequate charge storage capacitance.

The novel features believed characteristic of the invention are set forth in the appended claims. The invention itself however, as well as a preferred mode of use, and further objects and advantages thereof, will best be understood by reference to the following detailed description of an illustrative embodiment when read in conjunction with the accompanying drawings, wherein:

> **Figures 1 - 5** illustrate a preferred method for making dynamic random access memory cells according to the present invention; and
> **Figure 6** is a top view of several charge storage cells formed according to the method of **Figures 1 - 5**.

The process steps and structures described below do not form a complete process flow for manufacturing integrated circuits. The present invention can be practiced in conjunction with integrated circuit fabrication techniques currently used in the art, and only so much of the commonly practiced process steps are included as are necessary for an understanding of the present invention. The figures representing cross-sections of portions of an integrated circuit during fabrication are not drawn to scale, but instead are drawn so as to illustrate the important features of the invention.

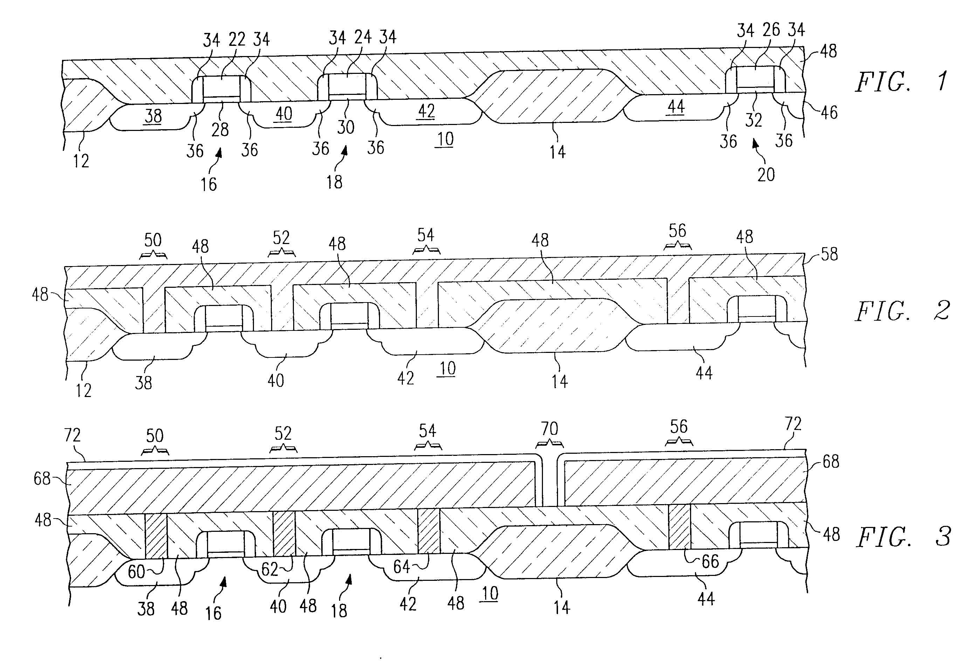

Referring to **Figure 1,** a DRAM cell will be formed in a substrate **10**. Active areas within the substrate **10** are separated by field oxide regions **14**. Transistors **16, 18, 20** will be formed in the substrate **10**.

As is known in the art, polycrystalline silicon, or silicided polycrystalline silicon, gate electrodes **22, 24, 26,** are formed over gate oxide layers **28, 30, 32**. Sidewall oxide regions **34** are formed along side each of the gate electrodes **22, 24, 26**. Lightly doped drain (LDD) regions **36** are formed adjacent to active regions **38, 40, 42, 44,** and **46**. Fabrication of the transistors **16, 18, 20,** to this point uses standard process techniques widely known in the art.

After formation of the transistors **16, 18, 20,** an oxide layer **48** is formed over the device. Oxide layer **48** is planarized according to techniques known in the art. For example, layer **48** can be composed of a thinner, undoped chemical vapor deposition (CVD) oxide layer, followed by a deposited reflowable glass, such as BPSG, or a spin-on glass. If desired, this layer can be etched back to decrease its thickness once it has been planarized.

Referring to **Figure 2,** the oxide layer **48** is patterned and etched to form contact openings **50, 52, 54,** and **56**. An anisotropic plasma etch is used, so that the openings **50 - 56** have substantially vertical sidewalls, and expose underlying active regions **38 - 44**. After formation of the openings, a tungsten layer **58** is deposited over the surface of the device.

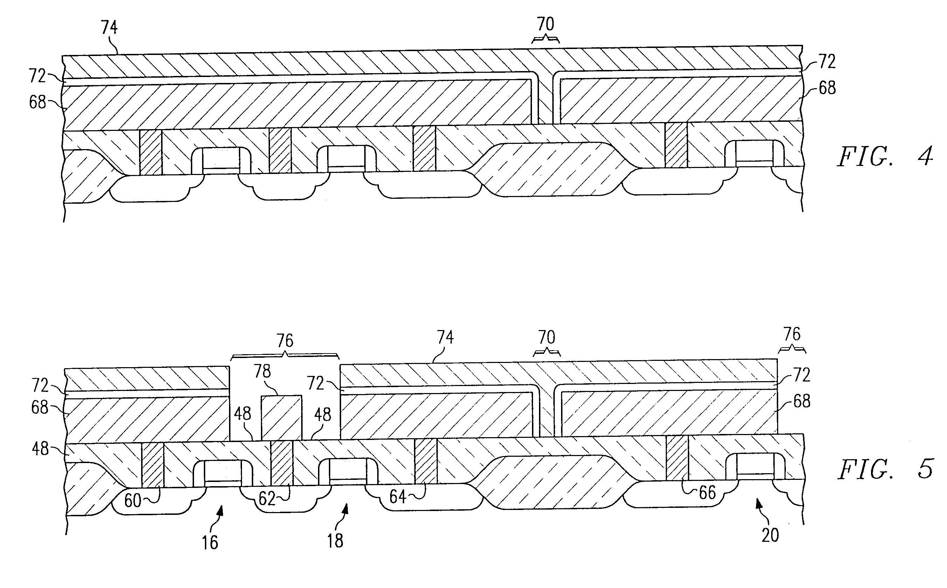

Referring to **Figure 3,** the tungsten layer **56** is anisotropically etched back to expose the upper surface of the oxide layer **48**. This leaves tungsten plugs **60, 62, 64,** and **66** remaining in openings **50 - 56**. These tungsten plugs **60 - 66** will be used to provide electrical contact between the underlying active regions **38 - 44,** and overlying conductive regions which have not yet been formed.

As an alternative to forming the tungsten layer **58** and etching it back to leave the tungsten plugs **60 66**, the plugs **60 - 66** can be grown directly using selective deposition of tungsten as known in the art. Under proper conditions, tungsten will deposit selectively on conductive areas, such as active regions **38 - 44,** and not on insulating regions, such as oxide layer **48**. This allows the tungsten plugs **60 - 66** to be grown directly to fill the openings **50 - 56**, without requiring the etch back step described above.

After the plugs **60 - 66** have been formed, a tantalum layer **68** is formed over the device. The tantalum layer **68** is then patterned to define charge storage plates for the DRAM cell capacitors. This includes the formation of openings **70** over field oxide region **14**. Eventually, Tungsten plug **62** will be a bit line contact to a shared bit line between transistor 16 and **18**. It is not necessary to open the tantalum layer **68** over the bit line at this time.

After patterning of the tantalum layer **68**, a tantalum oxide layer **72** is grown on the tantalum layer **68**. This oxide is preferably a high quality tantalum oxide approximately 500 angstroms thick, and may be grown in a furnace between approximately 500° and 800°c. The oxide layer **72** will be used to form the dielectric layer for the cell charge storage capacitors. Instead of growing the tantalum oxide dielectric layer **72**, tantalum oxide or another refractory metal oxide can be deposited using chemical vapor deposition. Alternatively, an oxide layer can be formed by sputtering tantalum on an oxygen ambient.

Referring to **Figure 4,** a tungsten layer **74** is grown over the tantalum oxide layer **72**. Tungsten layer **74** also fills the opening **70** between the patterned portions of the tantalum layer **68**.

Referring to **Figure 5,** a masked etch is used to define bit line contact openings **76**. Openings **76** are formed over the tungsten contact plugs **62** used to define the bit line. Openings **76** are made through the tungsten layer **74** and tantalum oxide layer **72**. opening **76** is oversized, and has a relatively loose tolerance for mask positioning. Another mask is then used to further pattern the tantalum layer **68** to define a bit line contact **78**. In the alternative, opening **76** can be made all the way down to the upper surface of oxide layer **48**, with a later bit line contact made directly to tungsten plug **62**.

Later process steps, such as formation of interlevel oxide layers, metalization, and passivation are performed as known in the art.

The structure shown in **Figure 5** provides a capacitor for each access transistor **16, 18, 20**. Tungsten plug **60** connects to a capacitor, and is connected to bit line **78**, through transistor **16**. Transistor **18** connects a capacitor to bit line **78** through tungsten plug **64**.

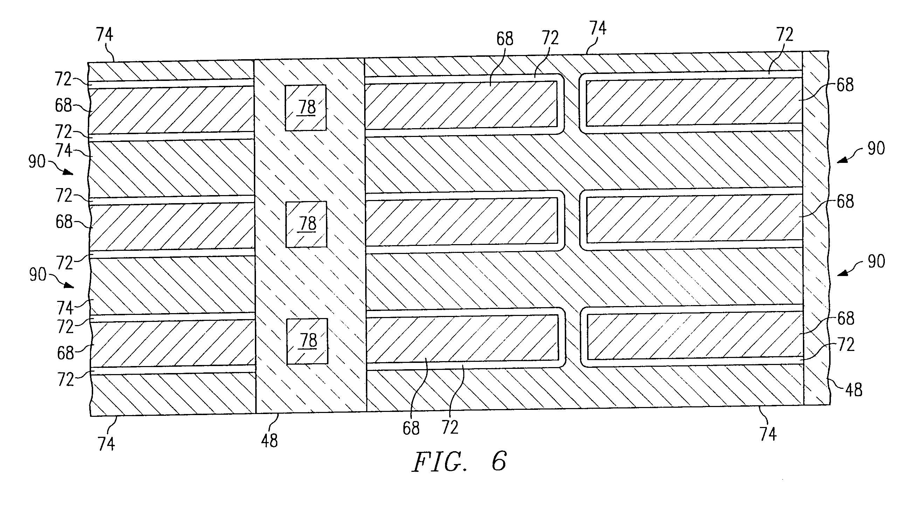

**Figure 6** shows a top view of a portion of an integrated circuit structure corresponding with the cross sectional view of **Figure 5**. **Figure 6** is actually a cross section through **Figure 5** taken just below the upper tantalum oxide layer **72**. **Figure 6** shows whole or partial capacitor structures for nine memory cells and shows three bit line contacts.

As shown in **Figure 6**, patterning the tantalum layer **68** to form opening **70** also forms spaces **90** between the charge storage plate regions **68**. The tantalum oxide layer **72** surrounds the patterned tantalum regions **68** on the sides, as shown in **Figure 6**, as well as on the top as shown in **Figure 5**. The tungsten reference plate **74** fills all of the spaces between the tantalum regions **68**, so that the capacitance of each capacitor is determined by the sidewall area of the patterned tantalum region **68** as well as the area of the top surface. This means that the capacitance of the capacitors can be increased simply by making the tantalum layer **68** thicker when it is deposited. This allows the height of the capacitors to be increased to balance any reductions which are made in its cross sectional area as shown in **Figure 6** when device feature sizes are decreased.

While the invention has been particularly shown and described with reference to a preferred embodiment, it will be understood by those skilled in the art that various changes in form and detail may be made therein without departing from the spirit and scope of the invention.

**Claims**

1.  A method for forming capacitors for a semiconductor integrated circuit device, comprising the steps of:
    forming a refractory metal layer on an insulating layer;
    patterning the refractory metal layer to define a plurality of capacitor charge storage plates;
    forming a dielectric layer over the charge storage plates, such dielectric being formed on sidewalls of the charge storage plates as well as upper surfaces thereof; and
    forming a metal layer over the charge storage plates and the insulating layer to define a capacitor reference plate.

2.  The method of Claim 1, further comprising the steps of:
    before said refractory metal forming step, forming a plurality of vias in the insulating layer, wherein the vias open underlying conductive regions for making contacts; and

filling the vias with a conductive material;

wherein the capacitor charge storage plates make electrical contact with the underlying conductive regions through the conductive material filling such vias.

3. A method for fabricating a dynamic random access memory cell, comprising the steps of:

forming an access transistor, such transistor having a control gate, and having first and second source/drain regions in a substrate;

forming an insulating layer over the access transistor and the substrate;

forming an opening through the insulating layer to expose a portion of the first source/drain region;

filling the opening with a conductive material;

forming a refractory metal layer over the insulating layer;

patterning the refractory metal layer to define a capacitor charge storage plate;

forming a dielectric layer over the charge storage plate, such dielectric being formed on sidewalls of the charge storage plate, as well as an upper surface thereof;

forming a metal layer over the charge storage plate and the insulating layer to define a capacitor reference plate.

4. The method of Claim 3, further comprising the steps of:

forming a second opening through the insulating layer to expose a portion of the second source/drain region;

filling the second opening with a conductive material; and

forming a bit line which makes contact to the second source/drain region through the conductive material in the second opening.

5. The method of Claim 4, wherein said second opening forming and filling steps occur simultaneously with said opening forming and filling steps, respectively, and wherein said bit line forming step is performed after said capacitor reference plate forming step.

6. The method of Claim 5, further comprising the step of:

after said capacitor reference plate forming step, patterning the metal layer to define a bit line contact over the second opening, wherein the bit line makes contact to the bit line contact.

7. A data storage device for a dynamic random access memory, comprising:

an insulating layer over a substrate;

an opening through said insulating layer to an underlying conductive region, said opening filled with a conductive material;

a refractory metal charge storage plate disposed on said insulating layer and covering said opening, whereby electrical contact is made between said charge storage plate and the underlying conductive region;

a dielectric layer covering sides and an upper surface of said charge storage plate; and

a refractory metal capacitor reference plate covering said dielectric layer and portions of said insulating layer adjacent said charge storage plate.

8. A data storage cell for a dynamic random access memory device according to Claim 7, further comprising:

an access transistor under said insulating layer and having a control gate, and first and second source/drain regions in a substrate, wherein the first source/drain region is the conductive region underlying said opening;

wherein the second source/drain region is electrically connected to a bit line.

9. The data storage cell of Claim 8, further comprising:

a second opening through said insulating layer, said second opening filled with a conductive material; and

a bit line crossing over said capacitor reference plate at approximately right angles to the access transistor control gate, said bit line electrically connected to the second source/drain region through said second opening.

10. The data storage cell of Claim 9, wherein both said first and said second openings are filled with the same material.

11. The data storage cell of Claim 10 or the method of Claim 2 or 4, wherein the conductive material filling said vias of Claim 2 or said first and second openings of claim 4 or 10 comprises a refractory metal.

12. The data storage cell or method of Claim 7 or 11, wherein the conductive material filling said vias of Claim 2 or said first and second openings of Claim 4 or 10 or said opening of Claim 7 comprises tungsten.

13. The data storage cell of Claim 7 or 12 or the method of Claim 1 or 3, wherein said charge storage plates of Claim 1 or plate, of Claim 3, 7 or 12 comprise tantalum.

14. The data storage cell or method of Claim 13 wherein said dielectric layer comprises tantalum oxide.

15. The method of Claim 14, wherein the tantalum oxide is grown over the charge storage plates of Claim 1 or plate of Claim 3 by heating them or it in an ambient containing oxygen.

16. The data storage cell of Claim 7 or 14 or the method of Claim 1, wherein said capacitor reference plate comprises tungsten.

*FIG. 1*

*FIG. 2*

*FIG. 3*

EP 0 508 760 A1

FIG. 4

FIG. 5

EP 0 508 760 A1

FIG. 6

**European Patent Office**

## EUROPEAN SEARCH REPORT

Application Number

EP 92 30 3134

### DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | PATENT ABSTRACTS OF JAPAN vol. 14, no. 401 (E-971)30 August 1990 & JP-A-2 151 060 ( HITACHI LTD ) 11 June 1990 * abstract * | 1-16 | H01L27/108 |
| A | PATENT ABSTRACTS OF JAPAN vol. 14, no. 387 (E-967)21 August 1990 & JP-A-2 142 175 ( HITACHI LTD ) 31 May 1990 * abstract * | 13-15 | |
| A | EP-A-0 386 947 (SGS-THOMSON) * abstract; figures * | 1-16 | |
| A | DE-A-4 028 488 (KABUSHIKI KAISHA TOSHIBA) * abstract; figures * | 1-16 | |
| A | PATENT ABSTRACTS OF JAPAN vol. 15, no. 94 (E-1041)6 March 1991 & JP-A-2 304 970 ( NEC CORP ) 18 December 1990 * abstract * | 1-16 | |
| A | IBM TECHNICAL DISCLOSURE BULLETIN. vol. 32, no. 9 B, February 1990, NEW YORK US pages 378 - 381; 'HIGH-DENSITY, FOLDED DRAM CELL' * PROCESS SEQUENCE STEP NUMBER 4 * | 1-16 | TECHNICAL FIELDS SEARCHED (Int. Cl.5 )  H01L |
| A | PATENT ABSTRACTS OF JAPAN vol. 14, no. 168 (E-912)(4111) 30 March 1990 & JP-A-2 023 657 ( SHARP CORP ) 25 January 1990 * abstract * | 1-16 | |
| A | PATENT ABSTRACTS OF JAPAN vol. 11, no. 288 (E-542)(2735) 17 September 1987 & JP-A-62 086 853 ( FUJITSU LTD ) 21 April 1987 * abstract * | 1-16 | |

The present search report has been drawn up for all claims

| Place of search | Date of completion of the search | Examiner |
|---|---|---|
| THE HAGUE | 23 JULY 1992 | SINEMUS M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)